# EUROPEAN PATENT APPLICATION

(11) **EP 1 191 735 A1**
(43) Date of publication of application: **27.03.2002**
(21) Application number: 00308384.7
(22) Date of filing: 25.09.2000
(51) Int. Cl.: H04L 7/033, H03M 1/36

(54) **Circuit arrangement for data and clock recovery**

(71) Applicant: LUCENT TECHNOLOGIES INC., Murray Hill, New Jersey 07974-0636 (US)
(72) Inventor: Dorschky, Claus, Eckental, 90542 Nuremberg (DE); Haunstein, Herbert, 91077 Nuremberg (DE); Schulien, Christoph, 90518 Altdorf bei Nuernberg (DE); Roell, Georg, 92353 Postbauer-Heng (DE); Sticht, Konrad, 92676 Eschenbach (DE); Sturm, Wolfgang, 90482 Nuremberg (DE)
(74) Representative: Buckley, Christopher Simon Thirsk

(57) **Abstract**

In order to provide high stability of the sampling phase in the course of data recovery and clock recovery from a predetermined input signal (Data_IN), a circuit arrangement (1) having a discretization apparatus (2) for data recovery and a discretization apparatus (3) for clock recovery is proposed, in which the two discretization apparatuses each at least have, on the input side, a decision device (40a, 40b; ... 56a, 56b) having an input at which a clock signal (CLOCK_IN) is present and an input at which the predetermined input signal is present, the decision devices both of the discretization apparatus for data recovery and of the discretization apparatus for clock recovery being essentially structurally identical and each comprising at least one comparator (40a, ..., 56a) with a storage device (40b, ..., 56b) assigned thereto. The symmetrical construction of all the decision devices of the circuit arrangement, the said decision devices being arranged on the input side, enables the devices to operate in phase. In addition, it may be provided that the decision devices of both discretization apparatuses are arranged electrically in parallel both with regard to the predetermined input signal and with regard to the clock signal present at the decision devices.

## Description

The invention relates to a circuit arrangement for data recovery and for clock recovery from a predetermined signal.

High-bit-rate transmission systems are being used to an increasing extent. In general, the data are sent digitally via a transmission channel and have to be recovered in the receiver. For this purpose, a discretization apparatus for recovering the clock signal and also a discretization apparatus for recovering the data are arranged in the respective receiving apparatus. In particular due to data signal distortion caused by transmission, for example due to linear or non-linear disturbances such as due to chromatic dispersion, polarization mode dispersion, wave mixing, etc. in monomode optical fibres, it is necessary to impose high requirements on the configuration of the aforementioned apparatuses in order to prevent intersymbol interference during sampling. By way of example, data recovery or data equalization may require sampling and A/D conversion at high speed, both quantification and time discretization of the continuous input signal being necessary. For this purpose, the clock signal must be recovered stably without phase fluctuations and a number of comparison operations must be carried out for quantification of the analogue signal.

Today's application specific integrated circuits (ASICs) of the apparatuses described use a separate phase detector (PD) for recovering the clock signal. In this case, the analogue data signal firstly passes through an automatic gain control (AGC) and is fed to the apparatuses for data recovery and for clock recovery on separate paths. A known problem of such apparatuses is clock phase drift, for example caused by different propagation times of the signals or impedances of the signal paths. According to the prior art, such phase shifts demand the use of controllable delay buffers or additional phase-locked loops (PLLs) in order to set the sampling phase and hold it in a stable manner.

Thus, the object of the invention is to provide a circuit arrangement for data recovery and for clock recovery from a predetermined input signal in which the problems outlined are at least reduced and the additional devices described can at least in part be obviated.

This object is actually achieved by the invention in a surprisingly simple manner by means of a circuit arrangement having the features of Claim 1. Accordingly, the circuit arrangement has one discretization apparatus for data recovery and a discretization apparatus for clock recovery from a predetermined input signal, the two discretization apparatuses each having, on the input side, at least one decision device having an input at which a clock signal is present and an input at which the predetermined input signal is present. In order to obtain a stable and fixed clock phase, it is provided that the decision devices both of the discretization apparatus for data recovery and of the discretization apparatus for clock recovery are essentially structurally identical, ideally constructionally identical, and each comprise at least one comparator with a storage device assigned thereto. The symmetrical construction of all the decision devices, which are arranged on the input side, enables the devices to operate essentially in phase.

Further advantageous embodiments of the invention are specified in the subclaims.

In order to further increase the temporal stability of the circuit arrangement, it may be provided that the decision devices of both discretization apparatuses are arranged electrically in parallel both with regard to the predetermined input signal and with regard to the clock signal present at the decision devices. In this case, the term "electrically in parallel" should be understood with regard to the high-frequency signals used, and in particular such that essentially identical signals are present at the individual decision devices, which signals, in particular, have no disturbing phase shifts or distortion with respect to one another. This can be achieved by the respective distributor structure with regard to feeding the predetermined input signal and the abovementioned clock signal being designed symmetrically for the decision devices arranged on the input side, with the result that all the assigned signals are subjected to essentially the same -phase changes up to the respective inputs of the decision devices, and are thus identical. Together with the structural identity of the individual decision devices already mentioned, the identical distribution of the input signal and of the clock signal can ensure particular stability of the sampling clock without the occurrence of phase fluctuations.

If the clock signal present at the individual decision devices, at the clock input of the storage device, is the feedback signal of a phase-locked loop of the apparatus for clock recovery, then the effect achieved is that all the decision devices of the circuit arrangement are driven identically with respect to time and thus operate in a phase-locked manner with respect to the feedback signal of the phase-locked loop.

The circuit arrangement according to the invention can be applied to a multiplicity of discretization apparatuses for data recovery. By way of example, the latter may be designed as an A/D converter (ADC) operating in parallel or else as a decision feedback equalizer (DFE). The circuit arrangement can advantageously be used for all fast, in particular optical, data transmission rates, for example at clock rates of greater than 1 gigabyte per second.

The invention is explained below by the description of two embodiments with reference to the drawings, in which
Fig. 1 shows the fundamental construction of the circuit arrangement (1) according to the invention in a first embodiment,
Fig. 2 shows the phase-locked loop for recovering the clock signal which is assigned to the embodiment shown in Fig. 1,
Fig. 3 shows a conventional circuit arrangement, and
Fig. 4 shows a second embodiment of the invention in a detail.

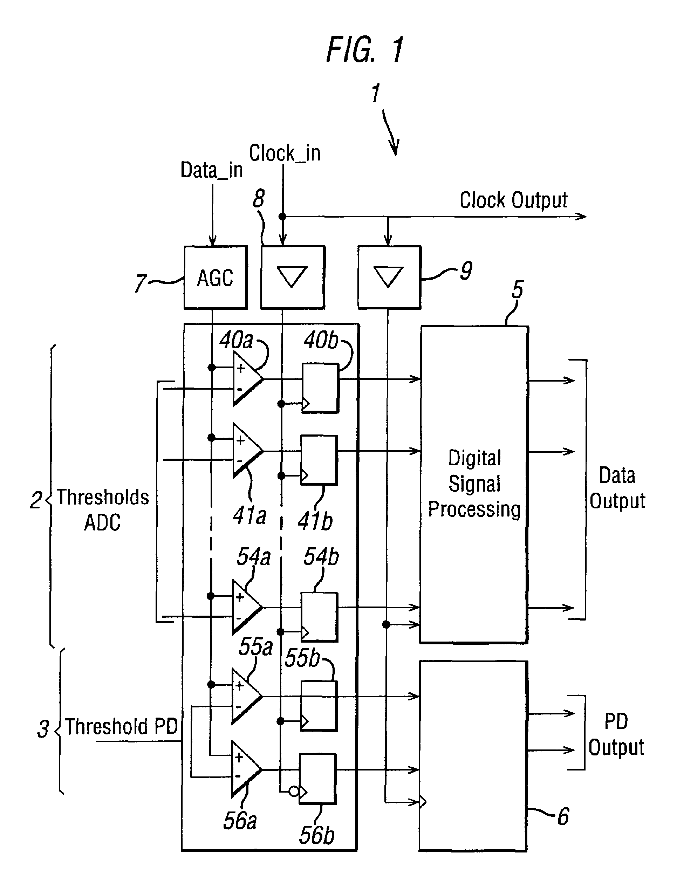

The circuit arrangement 1 according to the invention which is illustrated schematically in Fig. 1 has, on the input side, a total of 17 decision devices, only 5 of which are illustrated in the figure for reasons of clarity. Each decision device respectively comprises a comparator 40a, ..., 56a and a signal storage device 40b, ..., 56b assigned to the comparator, the said signal storage devices each being designed as digital flip-flops. All the decision devices of the circuit arrangement 1 according to the invention are structurally identical and receive the input signal DATA_IN amplified by means of an adaptive amplifier device (AGC: adaptive gain control) 7. A predetermined threshold voltage is present in each case at the other input of the comparators, this threshold voltage being identical for the comparators 55a and 56a. Furthermore, a clock signal CLOCK_IN is applied to all the flip-flops 40b, ..., 56b via the driver 8, the flip-flop 56b differing from the others in that inversion is performed at its clock input. Accordingly, the D flip-flops, triggered by the clock signal CLOCK_IN, switch the result of the voltage comparison by the comparator assigned thereto at predetermined instants onwards to the downstream circuit apparatuses 5 and 6, which are themselves triggered by the clock signal CLOCK_IN via the driver device 9.

The discretization apparatus designated by the reference symbol 2 is designed as an analogue/digital converter operating in parallel, the decision devices 40a, 40b; ...; 54a, 54b representing an input stage of the converter. The output signals of the 15 decision devices - only some of which are shown in Fig. 1. - of the discretization apparatus for data recovery are applied to the digital processing device 5, which, at predetermined instants, forms a 4-bit number from the said signals and outputs it at its output, this number corresponding to the analogue value at the inputs of the decision devices.

The two decision devices 55a, 55b and 56a, 56b form, together with the circuit device 6, the phase detector of a discretization apparatus for clock recovery from the predetermined input signal DATA_IN. The structural identity of the decision devices, arranged on the input side, of the circuit device 1 according to the invention and the parallel arrangement thereof with regard to the predetermined input signal and the clock signal as a result of the symmetrical, i.e. identical, distributor structure for feeding the respective signals to the specific devices ensure that, on the one hand, essentially identical input signals are present at all the devices and, on the other hand, essentially no different propagation times or signal distortions occur through the devices. There is no significantly disturbing effect here in the independent setting of the threshold values and of the offsets at the respective comparators 40a to 56a for digitizing the signal amplitude and, respectively, for detecting the phase of the clock signal. The two decision devices 55a, 55b and 56a, 56b form, together with the circuit device 6, a phase detector which is part of a phase-locked loop whose output signal serves, via the driver 8, on the one hand for triggering the analogue/digital apparatus and, on the other hand, for triggering the phase detector and thus for feedback into the phase detector. For this reason, there is no phase difference between the two discretization apparatuses 2, 3 with regard to the clock signal and to the input signal and both apparatuses operate in a phase-stable manner relative to one another.

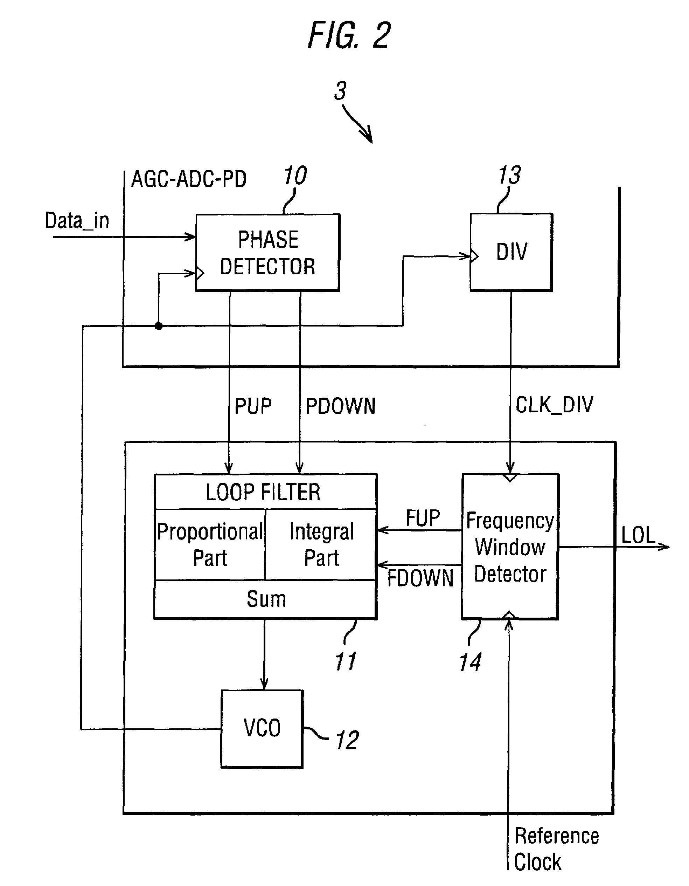

The phase-locked loop described is illustrated in Fig. 2. Accordingly, the two output signals of the phase detector are applied to a loop filter 11 having both a proportional part and an integral part. The output signal of the loop filter 11 drives an adjustable oscillator 12 (VCO: voltage controlled oscillator), whose output signal is fed back to the phase detector. For the sake of completeness, Fig. 2 also illustrates a capture aid comprising a divider 13 and a frequency window detector 14, which is driven by a reference clock signal and defines the sampling instant at the start until the capture of the clock signal. The detector 14 issues an alarm on its LOL line when the clock signal is lost. The sampling clock remains stable even if only the input devices of the analogue/digital converter 2 and of the phase detector, as depicted, are arranged symmetrically, for example on an individual IC, and, for example, the loop filter 11 and the controllable oscillator 12 connected downstream are arranged on a separate ASIC.

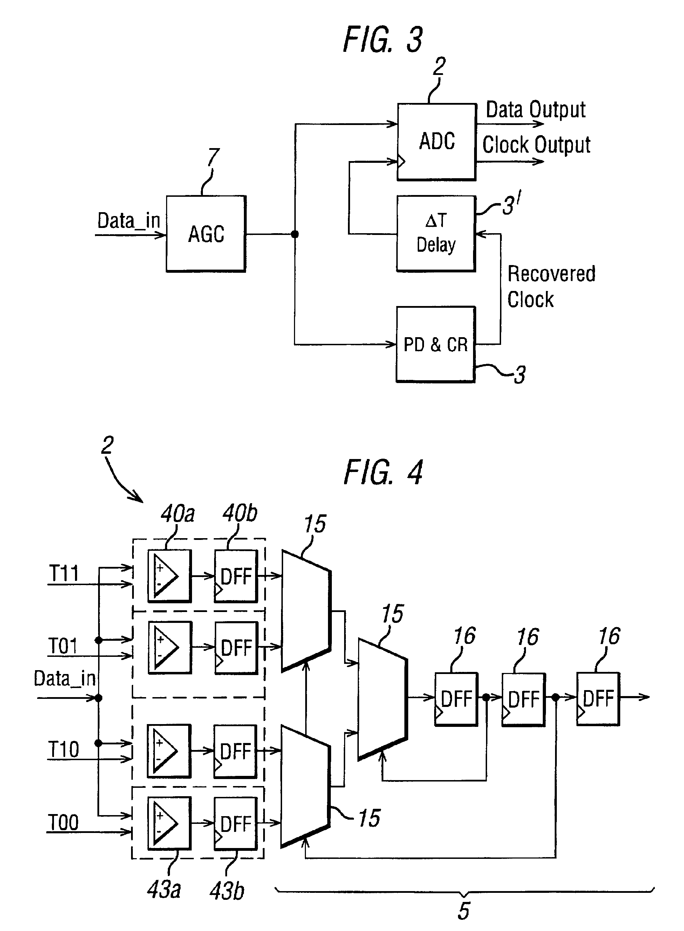

In order to illustrate the invention, Fig. 3 schematically illustrates a circuit arrangement having a discretization apparatus for data recovery and a discretization apparatus for clock recovery from a predetermined input signal according to the prior art. Accordingly, the input data signal once again passes through an adaptive amplifier 7 and is then split between an application specific integrated circuit for an analogue/digital converter 2 and an application specific integrated circuit for clock recovery 3 with the phase-locked loop. The clock signal determined in the discretization apparatus 3 is communicated to the data recovery apparatus 2. An apparatus 3' is necessary for adapting the sampling rate or sampling phase, which apparatus may comprise for example a delay buffer or a PLL control loop. In this case, the apparatus 3' serves to compensate for signal distortions or signal delays between the two circuits, in order to ensure the desired stable sampling. According to the invention, this apparatus serving in particular for phase shifting can be omitted since the relevant signals are present essentially identically at the electrical devices described.

In a further embodiment of the invention, the discretization apparatus for data recovery is designed as a decision feedback equalizer (DFE). Such an apparatus is shown in Fig. 4, the decision devices of the discretization apparatus for clock recovery and the downstream devices not being illustrated. In this embodiment, too, the input signal DATA_IN is split symmetrically between the individual decision devices 40a, 40b; ...; 43a, 43b, which each have different input thresholds T00...T11, each individual decision device once again comprising a comparator and a digital flip-flop. Finally, a decision concerning the discretization of the signal DATA_IN present at the input is carried out in the device 5 connected downstream of the decision device, the said device 5 having multiplexers 15 and further digital flip-flops 16. The method of operation is known according to the prior art and, in this respect, need not be discussed any further.

## Claims

1. Circuit arrangement (1) having at least one discretization apparatus (2) for data recovery and a discretization apparatus (3) for clock recovery from a predetermined input signal (Data_In), the discretization apparatuses (2, 3) each having, on the input side, at least one decision device (40a, 40b; ..; 56a, 56b) having at least one input at which a clock signal (CLOCK_In) is present and an input at which the predetermined input signal (Data_In) is present,
**characterized in that**
the decision devices (40a, 40b; ..; 56a, 56b) are essentially structurally identical and each comprise at least one comparator (40a, .., 56a) with a storage device (40b, .., 56b) assigned thereto.

2. Circuit arrangement according to Claim 1,
**characterized in that** decision devices of both discretization apparatuses (2, 3) are arranged electrically in parallel with regard to the predetermined input signal (Data_In) and a clock signal (CLOCK_In), the predetermined input signal (Data_In) in each case being present at an input of the comparator and the clock signal (CLOCK_In) being present at an input of the storage device.

3. Circuit arrangement according to Claim 1 or 2,
**characterized in that** the distributor structure for feeding the predetermined input signal (Data_In) to the individual decision devices (40a, 40b; ..; 56a, 56b) is essentially symmetrical, and **in that** the distributor structure for feeding the clock signal (CLOCK_In) to the individual decision devices (40a, 40b; ..; 56a, 56b) is essentially symmetrical, in such a way that an essentially identical input signal and an essentially identical clock signal are present at the assigned inputs of the decision devices (40a, 40b; ..; 56a, 56b).

4. Circuit arrangement according to one of Claims 1 to 3,
**characterized in that** the discretization apparatus (3) for clock recovery has at least one phase-locked loop (PLL) with the recovered clock signal as output signal, two of the decision devices (55a, 55b; 56a, 56b) being arranged as elements of the phase-locked loop and the clock signal (CLOCK_In) present at the respective signal storage devices (40b, 41b, ..., 55b, 56b) being the feedback signal of the phase-locked loop.

5. Circuit arrangement according to one of Claims 1 to 4;
**characterized in that** the discretization apparatus (2) for data recovery is designed as an analogue/digital converter (ADC) or as a decision feedback equalizer (DFE).

6. Use of a circuit arrangement according to one of Claims 1 to 5 for optical data transmission at a clock rate of greater than 1 Gbit/s.
